# EUROPÄISCHE PATENTSCHRIFT

(11) **EP 1 243 031 B1**
(45) Veröffentlichungstag und Bekanntmachung des Hinweises auf die Patenterteilung: **08.03.2017**
(21) Anmeldenummer: 00991779.0
(22) Anmeldetag: 28.12.2000
(51) Int. Cl.: H01L 33/48, H01L 33/50

(54) **OBERFLÄCHENMONTIERBARE LEUCHTDIODEN-LICHTQUELLE UND VERFAHREN ZUR HERSTELLUNG EINER LEUCHTDIODEN-LICHTQUELLE**
SURFACE MOUNTABLE LIGHT DIODE LIGHT SOURCE AND METHOD FOR PRODUCING A LIGHT DIODE LIGHT SOURCE
SOURCE LUMINEUSE A DIODES ELECTROLUMINESCENTES POUVANT ETRE MONTEE EN SURFACE ET PROCEDE DE PRODUCTION D'UNE SOURCE LUMINEUSE A DIODES ELECTROLUMINESCENTES

(30) Priorität: 30.12.1999 DE 19963806
(43) Veröffentlichungstag der Anmeldung: 25.09.2002
(73) Patentinhaber: OSRAM Opto Semiconductors GmbH, 93055 Regensburg (DE)
(72) Erfinder: JÄGER, Harald, 92536 Pfreimd (DE); HÖHN, Klaus, 82024 Taufkirchen (DE); BRUNNER, Reinhold, 93199 Zell (DE)
(74) Vertreter: Epping - Hermann - Fischer
(86) Internationale Anmeldenummer: PCT/DE2000/004660
(87) Internationale Veröffentlichungsnummer: WO 2001/050540

(56) Entgegenhaltungen:
- EP-A- 0 646 971
- WO-A-98/12757
- DE-U- 29 901 093
- PATENT ABSTRACTS OF JAPAN vol. 017, no. 325 (E-1384), 21. Juni 1993 (1993-06-21) & JP 05 037008 A (SHARP CORP), 12. Februar 1993 (1993-02-12)
- PATENT ABSTRACTS OF JAPAN vol. 1997, no. 07, 31. Juli 1997 (1997-07-31) & JP 09 083013 A (SHARP CORP), 28. März 1997 (1997-03-28)

## Beschreibung

Die Erfindung betrifft eine oberflächenmontierbare Leuchtdioden-Lichtquelle gemäß dem Oberbegriff des Patentanspruches 1.

Die Druckschrift WO-A-98/12575 beschreibt eine oberflächenmontierbare Leuchtdioden-Lichtquelle.

Die Druckschrift JP-A 5 037 008 beschreibt eine Vorrichtung zum optischen Koppeln.

Die Erfindung betrifft weiterhin ein Verfahren zur Herstellung einer Lichtquelle auf der Basis einer Halbleiter-Leuchtdiode (im Folgenden kurz Halbleiter-LED genannt), insbesondere einer oberflächenmontierbaren Halbleiter-LED, gemäß dem Oberbegriff des Patentanspruchs 9. Sie betrifft im Besonderen eine Halbleiter-LED-Mischlichtquelle, insbesondere eine Weißlichtquelle. Insbesondere wird bei dem erfindungsgemäßen Verfahren eine Halbleiter-LED mit einem Emissionsspektrum im ultravioletten oder blauen Spektralbereich verwendet und die Halbleiter-LED wird an ihren Lichtaustrittsseiten von einer Pressmasse umgeben, die einen Konversionsstoff enthält, durch den das von der Halbleiter-LED emittierte Lichtspektrum mindestens teilweise in Licht anderer Wellenlängen umgewandelt wird, so daß der optische Eindruck einer Weißlichtquelle entsteht, das heißt, daß die Lichtquelle insgesamt weißes Licht aussendet.

Ein oberflächenmontierbares LED-Bauelement mit vom Gehäuse abstehenden Lötanschlußteilen ist in der WO 98/12757 beschrieben. Bei diesem sind die Lötanschlußstreifen eines Leadframes ausgehend von der Chip-Montagefläche geradlinig in der Ebene der Montagefläche aus einem Kunststoffgehäuse herausgeführt und außerhalb des Kunststoffgehäuses zur Bauelement-Montageseite hin S-förmig gebogen, so daß im Anschluss an die S-Biegung Lötanschlussflächen entstehen. Mit den Lötanschlussflächen kann das Bauelement auf eine Leiterplatte montiert werden.

In der WO 98/12757 ist weiterhin eine wellenlängenkonvertierende Vergussmasse für ein elektrolumineszierendes Bauelement mit einem ultraviolettes, blaues, oder grünes Licht aussendenden Körper auf der Basis eines transparenten Epoxidharzes beschrieben, das mit einem Leuchtstoff, insbesondere mit einem anorganischen Leuchtstoffpigmentpulver mit Leuchtstoffpigmenten aus der Gruppe der Phosphore, versetzt ist. Als bevorzugtes Ausführungsform wird eine Weißlichtquelle beschrieben, bei welcher eine strahlungsemittierende Halbleiter-LED auf der Basis von GaAlN mit einem Emissionsmaximum zwischen 420 nm und 460 nm zusammen mit einem Leuchtstoff verwendet wird, der so gewählt ist, daß eine von dem Halbleiterkörper ausgesandte blaue Strahlung in komplementäre Wellenlängenbereiche, insbesondere blau und gelb, oder zu additiven Farbtripeln, z.B. blau, grün und rot, umgewandelt wird. Hierbei wird das gelbe bzw. das grüne und das rote Licht von den Leuchtstoffen erzeugt. Der Farbton (Farbort in der CIE-Farbtafel) des solchermaßen erzeugten weißen Lichts kann dabei durch geeignete Wahl des oder der Leuchtstoffe hinsichtlich Mischung und Konzentration variiert werden. Ebenso offenbart die WO 98/54929 ein sichtbares Licht emittierendes Halbleiterbauelement mit einer UV-/blau-LED, welche in einer Vertiefung eines Trägerkörpers angeordnet ist, deren Oberfläche eine lichtreflektierende Schicht aufweist und mit einem transparenten Material gefüllt ist, welches die LED an ihren Lichtaustrittsseiten umgibt. Zur Verbesserung der Lichtauskopplung weist das transparente Material einen Brechungsindex auf, der niedriger als der Brechungsindex der lichtaktiven Region der LED ist.

In der JP 05 037 008 ist ein oberflächenmontierbares LED-Bauelement beschrieben. Lötanschlussstreifen werden auf der Unterseite eines Kunststoffgießkörpers aus dem Kunststoffkörper herausgeführt. Die Lötanschlussstreifen sind an der Austrittstelle aus dem Kunststoffkörper so gebogen, daß ihre Enden an der Unterseite des Kunststoffkörpers entlang geradlinig horizontal nach außen zeigen.

In der DE 196 04 492 C1 ist eine sogenannte Radial-Bauform von LED-Bauelementen beschrieben. Eine derartige Bauform eignet sich nicht zu Oberflächenmontage, sondern ausschließlich zur Durchsteckmontage auf einer Leiterplatte. Der Kunststoff-Gehäuseverguß, der die Radialbauform im Wesentlichen definiert, besteht aus Polycarbonat.

In der JP-10093146 A ist ein Radial-LED-Bauelement beschrieben, bei dem zur Verbesserung der Strahlungsstärke und Helligkeit in den Kunstetoff- Gehäuseverguss ein Leuchtstoff eingebunden ist, der von der Strahlung des Halbleiter-LED-Chips angeregt wird und bei größerer Wellenlänge emittiert.

Eine Radial-LED-Bauform ist auch in der U.S. 5, 777, 433 beschrieben. Bei dieser sind in den Radial-Kunststoffverguss, der beispielsweise aus Epoxy oder einem anderen geeigneten transparenten organischen Vergussmaterial besteht, zur Erhöhung des Brechungsindex des Kunststoffmaterials Nanopartikel eingebunden, die einen größeren Brechungsindex aufweisen als das transparente Vergussmaterial

Aus der Offenlegungsschrift DE 38 04 293 ist eine Weißlichtquelle auf der Basis einer Halbleiter-LED bekannt. Darin ist eine Anordnung mit einer Elektrolumineszenz- oder Laserdiode beschrieben, bei der das von der Diode abgestrahlte Emissionsspektrum mittels eines mit einem phosphoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte Licht. Abhängig von der Art des im Kunststoff beigefügten Farbstoffes lassen sich mit ein und demselben Leuchtdiodentyp Leuchtdiodenanordnungen herstellen, die in unterschiedlichen Farben leuchten.

In vielen potentiellen Anwendungsgebieten für Leuchtdioden wie z.B. bei Anzeigeelementen im Kfz-Armaturenbereich, Beleuchtung in Flugzeugen und Autos und bei vollfarbtauglichen LED-Displays sowie in tragbaren Geräten mit Displayelementen oder hinterleuchteten Teilen (wie z.B. bei Mobiltelefonen), tritt verstärkt die Forderung nach besonders platzsparenden Leuchtdiodenanordnungen auf. Es werden insbesondere entsprechende LED-Bauelemente benötigt, mit denen sich mischfarbiges Licht, insbesondere weißes Licht, erzeugen läßt.

Bei den oben beschriebenen vorbekannten oberflächenmontierbaren Bauformen wird zunächst ein vorgehäustes Bauteil dadurch hergestellt, daß ein vorgefertigter Leiterrahmen (Leadframe) mit einem geeigneten Kunststoffmaterial umspritzt wird, welches das Gehäuse des Bauteils bildet. Dieses Bauteil weist an der Oberseite eine Vertiefung auf, in die von zwei gegenüberliegenden Seiten Leadframeanschlüsse eingeführt sind, auf dessen einem eine Halbleiter-LED aufgeklebt und elektrisch kontaktiert wird. In diese Vertiefung wird dann eine mit dem Leuchtstoff versetzte Vergussmasse, in der Regel ein transparentes Epoxidharz, eingefüllt.

Der Vorteil dieser bekannten oberflächenmontierbaren Bauformen liegt darin, dass eine sehr gerichtete Abstrahlung dadurch erreicht werden kann, indem die durch das Kunststoffgehäuse gebildeten Seitenwände als schräggestellte Reflektoren ausgebildet werden können. In den Anwendungsfällen, in denen jedoch eine derart gerichtete Abstrahlung nicht unbedingt erforderlich ist oder auf andere Weise erzielbar ist, stellt sich das Herstellungsverfahren als relativ aufwendig und mehrstufig dar, da der Gehäusekunststoff und die Vergussmasse aus zwei verschiedenen Materialien gebildet werden und in getrennten Verfahrensschritten angeformt werden müssen. Zudem muss stets das Problem einer ausreichenden und temperaturstabilen Haftung zwischen der Vergussmasse und dem Gehäusekunststoff gelöst werden. In der Praxis führt dies insbesondere bei Verwendung hoher Lichtleistungen immer wieder zu Problemen. Überdies ist die Miniaturisierbarkeit aufgrund des zweiteilig ausgebildeten Gehäuses begrenzt.

Die Miniaturisierbarkeit der oben beschriebenen Radialbauformen ist wegen der erforderlichen Durchsteckmontage ebenfalls stark eingeschränkt. Weiterhin stellt die Durchsteckmontage bei den heutzutage in der Regel in Oberflächenmontage hergestellten Schaltungsanordnungen einen separaten und gegenüber der Oberflächenmontage technisch anders gestalteten Montageschritt dar.

Der vorliegenden Erfindung liegt insbesondere die Aufgabe zugrunde, eine oberflächenmontierbare Leuchtdioden-Lichtquelle zur Verfügung zu stellen, die geringen Platzbedarf aufweist. Weiterhin soll ein Verfahren zur Herstellung einer Lichtquelle, insbesondere einer oberflächenmontierbaren Lichtquelle auf der Basis einer Halbleiter-LED angegeben werden, welches mit einer geringeren Anzahl von Herstellungsschritten auskommt, die gegenüber den bekannten Anordnungen verbesserte Eigenschaften hinsichtlich Temperaturfestigkeit im Gebrauch aufweist. Es soll weiterhin insbesondere die Herstellung einer mischfarbigen LED-Lichtquelle, besonders einer Weißlichtquelle angegeben werden.

Die erstgenannte Aufgabe wird durch eine oberflächenmontierbare Leuchtdioden-Lichtquelle mit den Merkmalen des Patentanspruchs 1 gelöst.

Bei der oberflächenmontierbaren Leuchtdioden-Lichtquelle der eingangs genannten Art weist gemäß der Erfindung jeder der Leadframeanschlüsse innerhalb des transparenten Kunststoff-Formkörpers eine S-artige Biegung auf, durch die dieser von einem Chipmontagebereich zu einer Montageseite der Leuchtdioden-Lichtquelle geführt ist.

Bei diesem Bauelement sind die Leadframeanschlüsse also bereits in dessen Montageebene aus dem Kunststoff-Gehäuse oder -Formkörper herausgeführt. Die Unterseiten der Leadframeanschlüsse führen folglich bereits in der Ebene der Unterseite des Kunststoff-Formkörpers aus diesem heraus und müssen außerhalb keine Biegung mehr aufweisen, die einerseits einen erhöhten Platzbedarf und andererseits eine mechanische Belastung des Kunststoff-Formkörpers während des Biegeverfahrens verursacht. Letztere birgt die Gefahr einer Delamination zwischen dem Kunststoff-Formkörper und dem Leadframe, was in der Regel zu einer verminderten Feuchtestabilität führt.

Bevorzugte Ausführungsformen der oberflächenmontierbaren Leuchtdioden-Lichtquelle sind Gegenstand der abhängigen Patentansprüche 2 bis 8.

Die zweitgenannte Aufgabe wird durch ein Verfahren mit den Merkmalen des Patentanspruches 9 gelöst.

Weiterbildungen des Verfahrens sind Gegenstand der Unteransprüche 10 bis 25.

Das Verfahren wird besonders bevorzugt zur Herstellung einer Weißlichtquelle auf der Basis einer Halbleiter-LED eingesetzt, welche Lichtstrahlung im ultravioletten oder blauen Spektralbereich emittiert, bei welchem Verfahren die LED auf einem Leadframe montiert und elektrisch kontaktiert wird, eine transparente Kunststoff- Pressmasse mit einem Konversionsstoff vermengt wird, und der Leadframe vorzugsweise im Spritzpressverfahren derart mit der Pressmasse umformt wird, daß die LED an ihren Lichtaustrittsseiten von der Pressmasse umgeben ist.

Das erfindungsgemäße Verfahren verzichtet somit auf die Formung einer Vertiefung und den Einsatz zweier unterschiedlicher Materialien und sieht statt dessen die Verwendung einer einzigen transparenten Kunststoff- Pressmasse vor, die zunächst mit dem Konversionsstoff vermengt wird und dann um den Leadframe geformt, vorzugsweise gespritzt wird. Die ausgehärtete Pressmasse dient somit gleichzeitig als Bauteilgehäuse als auch als transparente Konversionsstoffmatrix. Dadurch wird zum einen das Herstellungsverfahren erheblich vereinfacht, da in einem einzigen Anformprozess, insbesondere Spritzpressprozess, sowohl das Gehäuse gebildet als auch der Konversionsstoff bereitgestellt wird. Weiterhin wird ein Bauelement hergestellt, das verbesserte Stabilitätseigenschaften aufweist, da das Problem der Haftung zwischen zwei Materialien, die zudem verschiedene thermische Ausdehnungskoeffizienten aufweisen können, nicht mehr auftritt.

Es wird eine reproduzierbare und gezielte Einstellung der Farborte in engen Grenzen dadurch erreicht, dass die Sedimentation der Konversionsstoffe bei der Lagerung und Verarbeitung insbesondere durch schnelle Anhärteschritte weitestgehend ausgeschlossen wird. Die Qualität der Konversionsstoffe wird durch einfache Verfahrensschritte mit einfacheren Dosiermöglichkeiten und Minimierung der Abrasion bei der Harzaufbereitung, Mischung und Dosierung gesteigert.

Durch die Verarbeitung von Leuchtstoffen mit transparenten Festharzen mittels Pressmassenprozessen für Lumineszenzkonversionselemente wird das Sedimentationsverhalten der anorganischen Leuchtstoffe bei der Herstellung, Lagerung und Verarbeitung der Konverterharze entscheidend verbessert. Damit unterliegen die x,y-Farborte der Weißlichtquellen nur geringen Schwankungen und das Leuchtbild der Lumineszenzdioden wird verbessert. Langwieriges Eindispergieren des Leuchtstoffes für agglomeratfreie Konvertergießharze und zum Einstellen stabiler Viskositäten auch während der Gießharzlagerung entfällt genauso wie eine aufwendige Verpackung in Form von Spritzen. Im vorliegenden Fall werden transparente Pressmassen beispielsweise als Tabletten oder als Granulat zusammen mit dem Leuchtstoff durch Mahlen und ggf. Sieben miteinander vermischt. Sedimentation des Leuchtstoffes bei der Herstellung und Lagerung kann damit weitestgehend verhindert werden.

Durch die Verwendung nur noch eines einzigen Pressmassen-Formkörpers für die Gehäuseform und die Konversionsstoffmatrix ergibt sich Spielraum für eine weitere Miniaturisierung. Dieses zusätzliche Miniaturisierungspotential kann für die Anwendung dieser Weißlichtquellen in mobilen elektronischen Produktsystemen genutzt werden. Erhöhte Lichtausbeuten durch verstärktes Ausnutzen der Seitenstrahlung in speziellen Einbausituationen mit weiteren Gestaltungsfreiheitsgraden oder reine Seitenlichtauskopplungsmöglichkeiten erweitern die Funktionalität.

Die Kunststoff- Pressmasse kann als Ausgangsmaterial eine kommerziell erhältliche Pressmasse sein und besteht beispielsweise im wesentlichen aus einem Epoxykresolnovolak oder Epoxidharzsystemen mit einem Anhydrid- oder einem Phenolhärter-System.

Der Konversionsstoff kann ein anorganisches Leuchtstoffpigmentpulver mit Leuchtstoffpigmenten aus der Gruppe der Phosphore mit der allgemeinen Formel A₃B₅X₁₂ : M sein, welche in der Kunststoff- Pressmasse dispergiert sind. Insbesondere können als Leuchtstoffpigmente Partikel aus der Gruppe der Ce-dotierten Granate verwendet werden, wobei insbesondere Ce-dotierter Yttriumaluminiumgranat (Y₃Al₅O₁₂ : Ce) zu nennen ist. Weitere denkbare Konversionsstoffe sind Wirtsgitter auf Sulfid- und Oxysulfidbasis, Aluminate, Borate, etc. mit entsprechend im kurzwelligen Bereich anregbaren Metallzentren. Auch metallorganische Leuchtstoffsysteme sind zu berücksichtigen.

Der Leuchtstoff kann ebenso durch lösliche und schwer lösliche organische Farbstoffe und Leuchtstoffabmischungen gebildet werden.

Weiterhin kann dem vorzugsweise vorgetrockneten Konversionsstoff ein Haftvermittler vorzugsweise in flüssiger Form beigemengt werden, um die Haftfähigkeit des Konversionsstoffes mit der Kunststoff- Pressmasse zu verbessern. Insbesondere bei der Verwendung von anorganischen Leuchtstoffpigmenten kann als Haftvermittler 3-Glycidoxypropyltrimethoxysilan oder weitere Derivate auf Trialkoxysilan-Basis verwendet werden.

Zur Modifizierung der Leuchtstoffoberflächen können einfach- und mehrfachfunktionelle polare Agentien mit Carbonsäure-, Carbonsäureester-, Ether- und Alkoholgruppen, wie beispielsweise Diethylenglykolmonomethylether eingesetzt werden. Damit wird die Benetzbarkeit der hochenergetischen Leuchtstoffoberflächen und damit die Verträglichkeit und Dispergierung bei der Verarbeitung mit der Pressmasse verbessert.

Weiterhin kann der Kunststoff- Pressmasse vor dem Vermengen mit dem Konversionsstoff ein Entformungs- oder Trennmittel beigemengt werden. Derartige Entformungsmittel erleichtern das Herauslösen der ausgehärteten Pressmasse aus der Pressform. Als derartiges Entformungsmittel kann ein festes Entformungsmittel auf Wachsbasis oder eine Metallseife mit langkettigen Carbonsäuren, insbesondere Stearaten verwendet werden.

Als weitere Füllstoffe können beispielsweise anorganische Füllstoffe beigemengt werden, durch die der Brechungsindex der Pressmasse gesteigert werden kann, wodurch die Lichtausbeute der Weißlichtquelle erhöht werden kann. Als derartige Füllstoffe können beispielsweise TiO₂ ZrO₂, α-Al₂O₃, etc. eingesetzt werden.

Bevorzugterweise wird der Konversionsstoff und gegebenenfalls die weiteren Füllstoffe dadurch vermengt, indem sie zunächst grob gemischt werden und dann das Gemisch in einer Mühle gemahlen wird, wodurch ein sehr feines, homogenes Pulver gewonnen wird.

Die vermengte Pressmasse kann somit die folgenden Bestandteile (in Gew.-%) enthalten:
a) Kunststoff- Pressmasse ≥ 60%
b) Konversionsstoff > 0 und ≤ 40%
c) Haftvermittler ≥ 0 und ≤ 3%
d) Entformungsmittel ≥ 0 und ≤ 2%
e) Oberflächenmodifikator ≥ 0 und ≤ 5%
f) Oxidationsstabilisator ≥ 0 und ≤ 5% (z.B. auf Phosphitbasis oder auf Basis sterisch gehinderter Phenole)
g) UV-Lichtstabilisator ≥ 0 und ≤ 2%

In einer bevorzugten Ausführungsform kann das Verfahren derart durchgeführt werden, dass dabei ein oberflächenmontierbares Bauteil hergestellt wird.

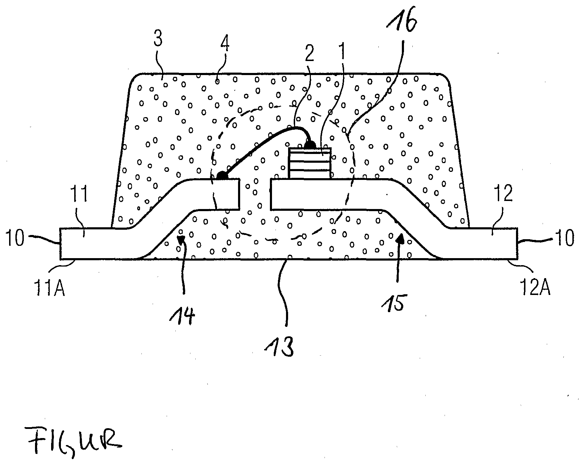

In der Figur der vorliegenden Anmeldung ist ein Ausführungsbeispiel einer erfindungsgemäß hergestellten Weißlichtquelle in einem Querschnitt entlang einer Längsachse eines Leadframes dargestellt.

In einem ursprünglich einstückigen und zusammenhängenden Leiterrahmen oder Leadframe 10 sind zwei Leadframeanschlüsse 11 und 12 ausgebildet, die in an sich bekannter Weise anfänglich noch durch schmale Verbindungsstege zusammengehalten werden, jedoch im Laufe einer im allgemeinen mehrstufigen Kunststoffumspritzung durch Auftrennen der Verbindungsstege voneinander isoliert werden. Auf einem Leadframeanschluss 12 wird auf dessen innenseitigem Endabschnitt eine fertigprozessierte Halbleiter-LED 1 mit einem elektrisch leitenden Verbindungsmittel wie Leitsilber oder dergleichen aufgeklebt, so daß die n- oder p-Seite der Halbleiter-LED 1 mit dem Leadframeanschluss 12 verbunden ist. Die gegenüberliegende n- oder p-leitende Kontaktseite wird durch einen Bonddraht 2 mit dem Endabschnitt des anderen Leadframeanschlusses 11 verbunden.

Das Leadframe 10, auf dem in einem Chipmontagebereich 16 der LED-Chip 1 montiert ist, ist mit einer transparenten Kunststoff- Pressmasse 3 umformt, aus der an zwei gegenüberliegenden Seitenflächen je ein Leadframeanschluss 11,12 herausragt. Innerhalb der transparenten Kunststoff- Pressmasse 3 weist jeder der Leadframeanschlüsse 11,12 eine S-artige Biegung 14,15 von einem Chipmontagebereich 16 zu einer Montageseite 13 der Leuchtdioden-Lichtquelle hin auf. Bevorzugt ist beispielsweise eine Kunststoff- Pressmasse 3 auf Harzbasis verwendet und besteht im wesentlichen aus einem vorreagierten Epoxidharz, insbesondere einem Epoxynovolak oder Epoxykresolnovolak besteht. Das Epoxidharz ist insbesondere mit einem Phenol- und/oder einem Anhydridhärter vorreagiert. Vorzugsweise ist der Kunststoff- Pressmasse ein Entformungs- oder Trennmittel beigemengt. Das Entformungsmittel ist beispielsweise ein festes Entformungsmittel auf Wachsbasis oder eine Metallseife mit langkettigen Carbonsäuren, insbesondere Stearaten.

Der Kunststoff- Pressmasse kann zur Erhöhung des Brechungsindex mindestens ein anorganischer Füllstoff wie TiO₂ ZrO₂ oder α-Al₂O₃ beigemengt sein.

Bei dem Verfahren zur Herstellung einer Leuchtdioden-Lichtquelle gemäß der Figur wird der LED-Chip 1 im Chipmontagebereich 16 auf dem Leadframe 10 montiert und mit den Leadframeanschlüssen 11,12 elektrisch leitend verbunden. Die Leadframeanschlüsse 11,12 werden vor oder nach dem Montieren des Halbleiter-LED-Chips 1 mit S-artigen Biegungen 14, 15 versehen. Der Halbleiter-LED-Chip 1 einschließlich der S-artigen Biegungen 14,15 des Leadframes 10 werden vorzugsweise im Pressverfahren mit einer transparenten Kunststoffpressmasse 3 umformt.

Bei einer Weißlichtquelle weist die Halbleiter-LED 1 ein Emissionsspektrum auf, das im ultravioletten oder blauen Spektralbereich liegt. Vorzugsweise ist die Halbleiter-LED 1 auf der Basis von GaN oder InGaN aufgebaut. Sie kann jedoch alternativ auch aus dem Materialsystem ZnS/ZnSe oder aus einem anderen für diesen Spektralbereich geeigneten Materialsystem bestehen.

Nach dem Aufbringen und Kontaktieren der Halbleiter-LED 1 wird in einer geeigneten Spritzpressapparatur eine transparente Kunststoff- Pressmasse 3 an die Leadframeanschlüsse 11 und 12 angespritzt. In diese Kunststoff- Pressmasse 3 sind Leuchtstoffpartikel 4 eingebettet, die aus einem Konversionsstoff bestehen, mit dem eine mindestens teilweise Wellenlängenkonversion der von der Halbleiter-LED 1 emittierten Lichtstrahlung herbeigeführt wird. Durch diese Wellenlängenkonversion wird ein Emissionsspektrum erzeugt, daß den optischen Eindruck einer Weißlichtquelle hervorruft. Die Vorfertigung des Leadframes 10 und die Umspritzung durch die aus der Kunststoff- Pressmasse 3, gegebenenfalls den Leuchtstoffpartikeln 4 und gegebenenfalls weiteren Füllstoffen bestehende Pressmasse erfolgt derart, daß die Leadframeabschnitte 11 und 12 horizontal aus der Pressmasse herausgeführt werden, und zwar derart, dass deren Löt-Anschlussflächen 11A und 12A im Wesentlichen in derselben Ebene liegen wie die Rückseite 13 des Vergusses, die in der Regel die Auflagefläche des Bauelements auf einer Leiterplatte darstellt. Die Leadframeanschlüsse 11 und 12 sind hierzu vor dem Umspritzen bereits in die endgültige Form gebogen. Sie weisen also die S-artigen Biegungen 14,15 vom Chipanschlußbereich 16 zur Montagefläche (gebildet von der Rückseite 13 und den Löt-Anschlussflächen 11A und 12A) hin bereits vor dem Umformen mit Kunststoff-Pressmasse auf, so daß nach dem Herstellen des Kunststoff-Formkörpers kein Biegestress mehr auf das Bauelement ausgeübt wird. Dies ist insbesondere bei stark miniaturisierten Bauelementen mit kleinvolumigem Kunststoffgehäuse von besonderem Vorteil, denn gerade hier besteht bei einer Delamination zwischen Pressmasse und Leadframe, ausgelöst beispielsweise durch Biegestress, eine sehr große Gefahr, daß keine hermetische Dichtigkeit des fertigen Bauteils erreicht wird.

Das fertige Bauteil kann vorteilhafterweise an den ebenen horizontalen Anschlussflächen 11A und 12A auf einer Leiterplatte (Platine) im Reflow-Verfahren aufgelötet werden. Dadurch wird ein für die SMT-(Surface Mounting Technology) Montage geeignetes Bauelement hergestellt.

Die Herstellung der durch die Kunststoff- Pressmasse 3, die Leuchtstoffpartikel 4 und gegebenenfalls weitere Füllstoffe gebildeten Pressmasse stellt ein wesentliches Element der vorliegenden Erfindung dar.

Als Ausgangsstoffe für die Kunststoff- Pressmasse werden vorzugsweise vorreagierte, lager- und strahlungsstabile transparente Pressmassen aus Epoxykresolnovolaken mit phenolischen Härtern verwendet, deren Gesamtchlorgehalt unterhalb 1500 ppm liegt. Vorzugsweise enthalten diese Pressmassen ein internes Entformungs- oder Trennmittel, durch welches das Herauslösen der ausgehärteten Pressmasse aus der Spritzpressform erleichtert wird. Das Vorhandensein eines derartigen internen Entformungsmittels stellt jedoch keine zwingende Notwendigkeit dar. Es können beispielsweise somit die folgenden kommerziell erhältlichen Preßmassen der Firmen Nitto und Sumitomo verwendet werden:
Nitto NT-600 (ohne internes Entformungsmittel)
Nitto NT-300H-10.000 (mit internem Entformungsmittel)
Nitto NT.300S-10.000 (mit internem Entformungsmittel)
Nitto NT 360- 10.000 (mit internem Entformungsmittel) Sumitomo EME 700L (ohne internes Entformungsmittel)

Diese Pressmassen werden standardmäßig in Stab- oder Tablettenform geliefert.

Als Konversionsstoffe können sämtliche Leuchtstoffe verwendet werden, die in den bereits genannten Druckschriften WO 97/ 50132 und WO 98/12757 beschrieben wurden. Darüber hinaus können auch Wirtsgitter auf Sulfid- und Oxysulfidbasis sowie Aluminate, Borate, etc. mit entsprechend im kurzwelligen Bereich anregbaren Metallzentren oder metallorganischen Leuchtstoffsysteme verwendet werden. Weiterhin können als Konversionsstoffe lösliche und schwer lösliche organische Farbstoffe und Leuchtstoffabmischungen eingesetzt werden. Insbesondere kann als Leuchtstoff ein anorganisches Leuchtstoffpigmentpulver mit Leuchtstoffpigmenten aus der Gruppe der Phosphore mit der allgemeinen Formel A₃B₅X₁₂:M verwendet werden, wobei besonders die Gruppe der Ce-dotierten Granate zu nennen ist. Insbesondere Partikel aus dem Leuchtstoffpigment YAG : Ce zeichnen sich durch besondere Konversionseffizienz aus. Dieser Konversionsstoff ist unter der Produktbezeichnung L175 der Fa. Osram bekannt. Mit diesem Konversionsstoff wurde ein Versuch zur Vermengung mit einer Pressmasse durchgeführt, wobei eine Pressmasse vom Typ Nitto NT-300 H10.000 mit internem Entformungsmittel zum Einsatz kam. Als Versuchsvorbereitung wurde der Konversionsstoff L175 bei 200°C für ca. 8h vorgetrocknet. Danach wurde ein Oberflächenmodifikator mit der Bezeichnung Diethylenglycolmonomethylether in Flüssigform dem vorgetrockneten Konverter beigemengt (0,1 Gew.-% bezogen auf Pressmassengewicht). Diese Mischung wurde in einem Glasgefäß luftdicht verschlossen und über Nacht stehengelassen. Direkt vor der Verarbeitung wurde der Konversionsstoff der Pressmasse des oben genannten Typs beigemengt. Die Pressmasse war vorher in einer Mühle (beispielsweise Kugelmühle) in Pulverform gemahlen worden. Das Mischungverhältnis betrug 20 Gew.-% Konversionsstoff/ DEGME-Mischung und 80 Gew.-% Nitto NT 300H-10.000. Nach dem groben Vermengen der Mischung durch Umrühren wurde das Gemisch erneut in einer Mühle (beispielsweise Kugelmühle) durchgemischt und gemahlen und somit sehr feines Pulver erzeugt.

Dann wurde mit dieser Pressmasse ein Spritzversuch auf der Apparatur vom Typ FICO Brilliant 100 durchgeführt. Die bereits entsprechend vorgefertigten Leadframes 10 wurden vor dem Umspritzen bei 150°C vorgewärmt und bei dem Umspritzen wurden die folgenden Maschinenparameter eingestellt:
Werkzeugtemperatur: 150°C
Spritzzeit: 22,4s
Spritzdruck: 73-82 bar (u.a. abhängig von der eingestellten Materialmenge)
Aushärtezeit (curing time: 120s)

Als Ergebnis konnte eine sehr homogene, ausgehärtete Pressmasse erzielt werden, die sich durch exzellente Blasen- und Lunkerfreiheit auszeichnete. Generell wurde festgestellt, daß das Vermahlen der Pressmasse zu sehr feinem Pulver vor der Vermengung bessere Ergebnisse hinsichtlich Blasen- und Lunkerfreiheit hervorbrachte als bei Verwendung eines grobkörnigeren Restmassenpulvers.

Zusätzlich kann auch noch ein Haftvermittler wie 3-Glycidoxypropyltrimethoxysilan, beispielsweise mit der Produktbezeichnung A-187 der Fa. Hüls AG, verwendet werden. Dieser Haftvermittler kann direkt nach dem Trockenprozess dem Leuchtstoff in Konzentrationen bis 3 Gew.-% zugegeben werden und über Nacht bei Raumtemperatur mit diesem vermischt werden.

Das erfindungsgemäße Verfahren ist gemäß Ausführungsbeispiel anhand einer SMD (surface mounted design)- Bauform beschrieben worden, wobei es jedoch ebenso bei einer sogenannten Radialdiode verwirklicht werden kann.

Das erfindungsgemäße Verfahren kann ebenso zur Herstellung eines in seitlicher Richtung, d.h. mit einer Hauptabstrahlrichtung parallel zur Ebene der Platine abstrahlenden LED-Bauelements angewandt werden.

## Patentansprüche

1. Oberflächenmontierbare Leuchtdioden-Lichtquelle, bei der auf einem Leadframe (10) ein LED-Chip (1) montiert ist und der Leadframe (10) mit einem einstückigen transparenten Kunststoff-Formkörper (3) umformt ist, aus dem an mindestens zwei Seitenflächen je ein Leadframeanschluß (11,12) für den LED-Chip (1) herausragt, wobei innerhalb des transparenten Kunststoff-Formkörpers (3) jeder der Leadframeanschlüsse (11,12) zwischen dem LED-Chip (1) und einer Montageseite (13) der Leuchtdioden-Lichtquelle eine S-artige Biegung (14,15) von einem Chipmontagebereich (16) zur Montageseite (13) der Leuchtdioden-Lichtquelle hin aufweist, die von dem Kunststoff-Formkörper (3) umformt ist.

2. Oberflächenmontierbare Leuchtdioden-Lichtquelle nach Anspruch 1,
**dadurch gekennzeichnet, dass** der transparente Kunststoff-Formkörper (3) aus einer Kunststoff- Pressmasse gefertigt ist.

3. Oberflächenmontierbare Leuchtdioden-Lichtquelle nach Anspruch 2,
**dadurch gekennzeichnet, dass** die Kunststoff-Pressmasse im wesentlichen vorreagiertes Epoxidharz, insbesondere Epoxynovolak oder Epoxykresolnovolak aufweist.

4. Oberflächenmontierbare Leuchtdioden-Lichtquelle nach Anspruch 3,
**dadurch gekennzeichnet, dass** das Epoxidharz mit einem Phenol- und/oder einem Anhydridhärter vorreagiert ist.

5. Oberflächenmontierbare Leuchtdioden-Lichtquelle nach einem der Ansprüche 2 bis 4,
**dadurch gekennzeichnet, dass** der Kunststoff-Pressmasse ein Entformungs- oder Trennmittel beigemengt ist.

6. Oberflächenmontierbare Leuchtdioden-Lichtquelle nach Anspruch 5,
**dadurch gekennzeichnet, dass** das Entformungsmittel ein festes Entformungsmittel auf Wachsbasis oder eine Metallseife mit langkettigen Carbonsäuren, insbesondere Stearaten, ist.

7. Oberflächenmontierbare Leuchtdioden-Lichtquelle nach einem der Ansprüche 2 bis 6,
**dadurch gekennzeichnet, dass** der Kunststoff-Pressmasse mindestens ein anorganischer Füllstoff wie TiO₂ ZrO₂ oder α-Al₂O₃ beigemengt ist, durch die der Brechungsindex der Pressmasse gesteigert ist.

8. Oberflächenmontierbare Leuchtdioden-Lichtquelle nach einem der Arisprüche 2 bis 7,
**dadurch gekennzeichnet, dass** der Kunststoff-Pressmasse mindestens ein organischer oder anorganischer Konversionsstoff beigemengt ist, der einen Teil der von dem LED-Chip ausgesandten Strahlung absorbiert und eine gegenüber der absorbierten Strahlung längerwellige Strahlung emittiert, so dass die Lichtquelle mischfarbiges Licht aus Primärlicht des LED-Chips und Sekundärlicht des Konversionsstoffes emittiert.

9. Verfahren zur Herstellung einer Leuchtdioden-Lichtquelle gemäß einem der Ansprüche 1 bis 8, bei welchem
- der LED-Chip (1) in einem Chipmontagebereich (16) auf einem Leadframe (10) montiert und mit Leadframeanschlüssen (11,12) elektrisch leitend verbunden wird,
- die Leadframeanschlüsse (11,12) vor oder nach dem Montieren des LED-Chips (1) mit S-artigen Biegungen (14,15) versehen werden und
- der LED-Chip (1) einschließlich der S-artigen Biegungen (14,15) des Leadframes (10) mit einer transparenten Kunststoffpressmasse (3) umformt wird.

10. Verfahren nach Anspruch 9,
**dadurch gekennzeichnet, dass** eine Kunststoff-Pressmasse (3) auf Harzbasis verwendet wird.

11. Verfahren nach Anspruch 10,
**dadurch gekennzeichnet, dass** die Kunststoff-Pressmasse 3) im wesentlichen aus einem vorreagierten Epoxidharz, insbesondere einem Epoxynovolak oder Epoxykresolnovolak besteht.

12. Verfahren nach Anspruch 11,
**dadurch gekennzeichnet, dass** das Epoxidharz mit einem Phenol- und/oder einem Anhydridhärter vorreagiert ist.

13. Verfahren nach einem der Ansprüche 9 bis 12, **d**
**adurch gekennzeichnet**, dass die transparente Kunststoff-Pressmasse mit einem Konversionsstoff vermengt wird und der Konversionsstoff (4) ein organischer oder anorganischer Leuchtstoff oder eine Mischung davon ist.

14. Verfahren nach Anspruch 13,
**dadurch gekennzeichnet, dass** der Konversionsstoff (4) ein anorganischer Leuchtstoff ist und ein Leuchtstoffmetallzentrum M in einem Wirtsgitter auf der Basis
- der allgemeinen Formel A₃B₅X₁₂ oder
- eines Sulfids, Oxysulfids, Borats, Aluminats oder von Metallchelatkomplexen enthält.

15. Verfahren nach Anspruch 13 oder 14,
**dadurch gekennzeichnet, dass** - dem vorzugsweise vorgetrocknetem Konversionsstoff (4) vor dem Vermengen der Kunststoff-Pressmasse (3) ein Haftvermittler vorzugsweise in flüssiger Form beigemengt wird, um die Haftfähigkeit des Konversionsstoffes (4) mit der Kunststoff- Pressmasse (3) zu verbessern.

16. Verfahren nach einem der Ansprüche 9 bis 15,
**dadurch gekennzeichnet, dass** - als Haftvermittler 3-Glycidoxypropyltrimethoxysilan oder weitere Derivate auf Trialkoxysilan-Basis verwendet werden.

17. Verfahren nach einem der Ansprüche 13 bis 16,
**dadurch gekennzeichnet, dass** -dem vorzugsweise vorgetrockneten Konversionsstoff (4) vor dem Vermengen der Kunststoff-Pressmasse (3) ein Oberflächenmodifikator vorzugsweise in flüssiger Form beigemengt wird, um die Oberflächen des Konversionsstoffes (4) zu modifizieren.

18. Verfahren nach Anspruch 17,
**dadurch gekennzeichnet, dass** - als Oberflächenmodifikator Diethylenglycolmonomethylether verwendet wird.

19. Verfahren nach einem der Ansprüche 13 bis 18, **dadurch gekennzeichnet, dass** der
Kunststoff-Pressmasse vor dem Vermengen mit dem Konversionsstoff (4) ein Entformungs- oder Trennmittel beigemengt wird.

20. Verfahren nach Anspruch 19,
**dadurch gekennzeichnet, dass** das Entformungsmittel ein festes Entformungsmittel auf Wachsbasis oder eine Metallseife mit langkettigen Carbonsäuren, insbesondere Stearaten, ist.

21. Verfahren nach einem der Ansprüche 9 bis 20, **dadurch gekennzeichnet, dass** -der Pressmasse zusätzlich anorganische Füllstoffe wie TiO₂ ZrO₂ oder α-Al₂O₃ beigemengt werden, durch die der Brechungsindex der Pressmasse gesteigert wird.

22. Verfahren nach einem der Ansprüche 13 bis 20, **d**
**adurch gekennzeichnet**, dass die Kunststoff-Pressmasse (3) und der Konversionsstoff (4) und gegebenenfalls weitere Füllstoffe vermengt werden, indem sie zunächst grob gemischt werden und dann das Gemisch in einer Mühle wie einer Kugelmühle gemahlen wird, wodurch ein sehr feines, homogenes Pulver gewonnen wird.

23. Verfahren nach Anspruch 22,
**dadurch gekennzeichnet, dass** die Kunststoff-Pressmasse (3) vor dem Mischen mit dem Konversionsstoff (4) und gegebenenfalls den weiteren Füllstoffen in einer Mühle wie einer Kaffeemühle gemahlen wird.

24. Verfahren nach einem der Ansprüche 9 bis 23,
**dadurch gekennzeichnet, dass** -die vermengte Pressmasse die folgenden Bestandteile enthält:
a) Kunststoff- Pressmasse ≥ 60%
b) Konversionsstoff > 0 und ≤ 40%
c) Haftvermittler ≥ 0 und ≤ 3%
d) Entformungsmittel ≥ 0 und ≤ 2%
e) Oberflächenmodifikator ≥ 0 und ≤ 5%
f) Oxidationsstabilisator ≥ 0 und ≤ 5% (z.B. auf Phosphitbasis oder auf Basis sterisch gehinderter Phenole)
g) UV-Lichtstabilisator ≥ 0 und ≤ 2%

25. Verfahren nach einem der Ansprüche 9 bis 24,
**dadurch gekennzeichnet, dass** -die Lichtquelle als oberflächenmontierbares Bauelement hergestellt wird, indem die Pressmasse derart geformt ist, dass auf einer Montageseite der fertiggestellten Weißlichtquelle Leadframeanschlüse (11, 12) seitlich unter Bildung horizontaler Montageflächen (11A, 12A) aus der Pressmasse herausgeführt werden.

## Claims

1. Surface-mountable light-emitting diode light source, in which an LED chip (1) is mounted on a leadframe (10) and the leadframe (10) is encapsulated with a one-piece transparent plastic molded body (3), from which a leadframe connection (11, 12) for the LED chip (1) protrudes on each of at least two side faces, wherein, within the transparent plastic molded body (3), each of the leadframe connections (11, 12) has between the LED chip (1) and a mounting side (13) of the light-emitting diode light source an S-like bend (14,15) from a chip mounting region (16) to the mounting side (13) of the light-emitting diode light source, which is encapsulated by the plastic molded body (3).

2. Surface-mountable light-emitting diode light source according to Claim 1, **characterized in that** the transparent plastic molded body (3) is produced from a plastics molding composition.

3. Surface-mountable light-emitting diode light source according to Claim 2, **characterized in that** the plastics molding composition substantially comprises a pre-reacted epoxy resin, in particular an epoxy novolak or epoxy cresol novolak.

4. Surface-mountable light-emitting diode light source according to Claim 3, **characterized in that** the epoxy resin is pre-reacted with a phenol and/or anhydride hardener.

5. Surface-mountable light-emitting diode light source according to one of Claims 2 to 4, **characterized in that** a demolding or release agent is admixed with the plastics molding composition.

6. Surface-mountable light-emitting diode light source according to Claim 5, **characterized in that** the demolding agent is a solid wax-based demolding agent or a metallic soap with long-chain carboxylic acids, in particular stearates.

7. Surface-mountable light-emitting diode light source according to one of Claims 2 to 6, **characterized in that** at least one inorganic filler, such as TiO₂, ZrO₂ or α-Al₂O₃, is admixed with the plastics molding composition, by which the refractive index of the molding composition is increased.

8. Surface-mountable light-emitting diode light source according to one of Claims 2 to 7, **characterized in that** at least one organic or inorganic conversion substance, which absorbs part of the radiation emitted by the LED chip and emits a longer-wave radiation in comparison with the absorbed radiation, is admixed with the plastics molding composition, so that the light source emits mixed-colored light comprising primary light of the LED chip and secondary light of the conversion substance.

9. Method of producing a light-emitting diode light source according to one of Claims 1 to 8, in which
- the LED chip (1) is mounted in a chip mounting region (16) on a leadframe (10) and is connected in an electrically conducting manner to leadframe connections (11, 12),
- the leadframe connections (11, 12) are provided with S-like bends (14, 15) before or after the mounting of the LED chip (1) and
- the LED chip (1), including the S-like bends (14, 15) of the leadframe (10), is encapsulated with a transparent plastics molding composition (3).

10. Method according to Claim 9, **characterized in that** a resin-based plastics molding composition (3) is used.

11. Method according to Claim 10, **characterized in that** the plastics molding composition (3) substantially comprises a pre-reacted epoxy resin, in particular an epoxy novolak or epoxy cresol novolak.

12. Method according to Claim 11, **characterized in that** the epoxy resin is pre-reacted with a phenol and/or anhydride hardener.

13. Method according to one of Claims 9 to 12, **characterized in that** the transparent plastics molding composition is mixed with a conversion substance and the conversion substance (4) is an organic or inorganic luminescent substance or a mixture thereof.

14. Method according to Claim 13, **characterized in that** the conversion substance (4) is an inorganic luminescent substance and contains a luminescent substance metal center (M) in a host lattice on the basis of
- the general formula A₃B₅X₁₂ or
- a sulfide, oxysulfide, borate, aluminate or metal-chelate complexes.

15. Method according to Claim 13 or 14, **characterized in that**, before the mixing of the plastics molding composition (3), an adhesion promoter, preferably in liquid form, is admixed with the preferably pre-dried conversion substance (4), in order to improve the adhesiveness of the conversion substance (4) with the plastics molding composition (3).

16. Method according to one of Claims 9 to 15, **characterized in that** 3-glycidoxypropyltrimethoxy-silane or further trialkoxysilane-based derivatives are used as adhesion promoters.

17. Method according to one of Claims 13 to 16, **characterized in that**, before the mixing of the plastics molding composition (3), a surface modifier, preferably in liquid form, is admixed with the preferably pre-dried conversion substance (4), in order to modify the surfaces of the conversion substance (4).

18. Method according to Claim 17, **characterized in that** diethyleneglycolmonomethylether is used as the surface modifier.

19. Method according to one of Claims 13 to 18, **characterized in that**, before the mixing with the conversion substance (4), a demolding or release agent is admixed with the plastics molding composition.

20. Method according to Claim 19, **characterized in that** the demolding agent is a solid wax-based demolding agent or a metallic soap with long-chain carboxylic acids, in particular stearates.

21. Method according to one of Claims 9 to 20, **characterized in that** inorganic fillers, such as TiO₂, ZrO₂ or α-Al₂O₃, are additionally admixed with the molding composition, by which the refractive index of the molding composition is increased.

22. Method according to one of claims 13 to 20, **characterized in that** the plastics molding composition (3) and the conversion substance (4) and possibly further fillers are mixed **in that** they are initially coarsely mixed and then the mixture is ground in a mill such as a ball mill, whereby a very fine, homogeneous powder is obtained.

23. Method according to Claim 22, **characterized in that**, before the mixing with the conversion substance (4) and possibly the further fillers, the plastics molding composition (3) is milled in a mill like a coffee mill.

24. Method according to one of Claims 9 to 23, **characterized in that** the mixed molding composition contains the following constituents:
a) plastics molding composition ≥ 60%
b) conversion substance > 0 any ≤ 40%
c) adhesion promoters ≥ 0 and ≤ 3%
d) demolding agents ≥ 0 and ≤ 2%
e) surface modifier ≥ 0 and ≤ 5%
f) oxidation stabilizer ≥ 0 and ≤ 5% (for example phosphite-based or based on stearically hindered phenols)
g) UV light stabilizer ≥ 0 and ≤ 2%.

25. Method according to one of Claims 9 to 24, **characterized in that** the light source is produced as a surface-mountable component **in that** the molding composition is molded in such a way that, on a mounting side of the completed white-light source, leadframe connections (11, 12) are led out laterally from the molding composition, thereby forming horizontal mounting surfaces (11A, 12A).

## Revendications

1. Source lumineuse à diodes électroluminescentes pouvant être montée en surface, dans laquelle une puce à diodes électroluminescentes (1) est montée sur un réseau de conducteurs (10) et le réseau de conducteurs (10) est mis sous forme avec un corps en matière plastique (3), lequel est transparent et moulé en une seule pièce et duquel dépasse respectivement, au niveau d'au moins deux faces latérales, une connexion pour le réseau de conducteurs (11, 12) pour la puce à diodes électroluminescentes (1), où chacune des connexions pour le réseau de conducteurs (11, 12) se trouvant entre la puce à diodes électroluminescentes (1) et une face de montage (13) de la source lumineuse à diodes électroluminescentes présente, à l'intérieur du corps moulé et transparent en matière plastique (3), une courbure (14, 15) en forme de « S », partant d'une zone de montage de la puce (16) en allant vers la face de montage (13) de la source lumineuse à diodes électroluminescentes qui est mise sous forme par le corps moulé et transparent en matière plastique (3).

2. Source lumineuse à diodes électroluminescentes pouvant être montée en surface selon la revendication 1,
**caractérisée en ce que**
le corps moulé et transparent en matière plastique (3) est fabriqué à partir d'un composé de moulage en matière plastique.

3. Source lumineuse à diodes électroluminescentes pouvant être montée en surface selon la revendication 2,
**caractérisée en ce que**
le composé de moulage en matière plastique (3) présente pour l'essentiel une résine époxy soumise à une mise en réaction préalable, en particulier un revêtement époxy novolaque ou un revêtement novolaque d'époxyde-crésol.

4. Source lumineuse à diodes électroluminescentes pouvant être montée en surface selon la revendication 3,
**caractérisée en ce que**
la résine époxy est soumise à une mise en réaction préalable avec un agent de polymérisation phénolé et/ou un agent de polymérisation anhydride.

5. Source lumineuse à diodes électroluminescentes pouvant être montée en surface selon l'une des revendications 2 à 4,
**caractérisée en ce que**
un agent de démoulage ou un agent de séparation est mélangé au composé de moulage en matière plastique.

6. Source lumineuse à diodes électroluminescentes pouvant être montée en surface selon la revendication 5,
**caractérisée en ce que**
l'agent de démoulage est un agent de démoulage solide à base de cire ou un savon métallique avec des acides carboxyliques à chaînes longues, en particulier des stéarates.

7. Source lumineuse à diodes électroluminescentes pouvant être montée en surface selon l'une des revendications 2 à 6,
**caractérisée en ce que**
au moins une charge de remplissage anorganique, telle que du TiO₂, du ZrO₂ ou du α-Al₂O₃, est mélangée au composé de moulage en matière plastique, par l'intermédiaire de laquelle charge de remplissage l'indice de réfraction du composé de moulage est augmenté.

8. Source lumineuse à diodes électroluminescentes pouvant être montée en surface selon l'une des revendications 2 à 7,
**caractérisée en ce que**
au moins une matière de conversion organique ou anorganique est mélangée au composé de moulage en matière plastique, laquelle matière de conversion absorbe une partie du rayonnement émis par la puce à diodes électroluminescentes et émet un rayonnement dont la longueur d'onde est supérieure au rayonnement absorbé, de telle sorte que la source lumineuse émet une lumière mixte étant constituée de la lumière primaire de la puce à diodes électroluminescentes et de la lumière secondaire de la matière de conversion.

9. Procédé destiné à la production d'une source lumineuse à diodes électroluminescentes selon l'une des revendications 1 à 8, dans lequel :
- la puce à diodes électroluminescentes (1) est montée sur un réseau de conducteurs (10), dans une zone de montage de la puce (16), et est raccordée aux connexions pour le réseau de conducteurs (11, 12) de manière à assurer une conduction électrique ;
- les connexions pour le réseau de conducteurs (11, 12) se trouvant en amont ou en aval du montage de la puce à diodes électroluminescentes (1) sont dotées de courbures (14, 15) en forme de « S » ;
- la puce à diodes électroluminescentes (1), y compris les courbures (14, 15) en forme de « S » du réseau de conducteurs (10), est mise sous forme avec un composé de moulage transparent en matière plastique (3).

10. Procédé selon la revendication 9,
**caractérisé en ce que**
un composé de moulage en matière plastique (3) à base de résine est employé.

11. Procédé selon la revendication 10,
**caractérisé en ce que**
le composé de moulage en matière plastique (3) est composé pour l'essentiel à partir d'une résine époxy soumise à une mise en réaction préalable, en particulier d'un revêtement époxy novolaque ou d'un revêtement novolaque d'époxyde-crésol.

12. Procédé selon la revendication 11,
**caractérisé en ce que**
la résine époxy est soumise à une mise en réaction préalable avec un agent de polymérisation phénolé et/ou un agent de polymérisation anhydride.

13. Procédé selon l'une des revendications 9 à 12,
**caractérisé en ce que**
le composé de moulage transparent en matière plastique est mélangé avec une matière de conversion et la matière de conversion (4) est une substance luminescente organique ou anorganique ou un mélange de celle-ci.

14. Procédé selon la revendication 13,
**caractérisé en ce que**
la matière de conversion (4) est une substance luminescente anorganique et contient un centre métallique de substance luminescente « M » dans une grille hôte sur la base :
- de la formule générale A₃B₅X₁₂ ou
- d'un sulfure, d'un oxysulfure, d'un borate, d'un aluminate ou de complexes métalliques de chélates.

15. Procédé selon la revendication 13 ou 14,
**caractérisé en ce que**
un agent d'adhérence, de préférence sous une forme liquide, est mélangé à la matière de conversion (4), de préférence préalablement séchée, avant le mélange du composé de moulage en matière plastique (3), afin d'améliorer l'adhérence de la matière de conversion (4) avec le composé de moulage en matière plastique (3).

16. Procédé selon l'une des revendications 9 à 15,
**caractérisé en ce que**
du 3-glycidoxypropyltriméthoxysilane ou d'autres dérivés à base de trialcoxysilane est employé comme agent d'adhérence.

17. Procédé selon l'une des revendications 13 à 16,
**caractérisé en ce que**
un modificateur de surface, de préférence sous une forme liquide, est mélangé à la matière de conversion (4), de préférence préalablement séchée, avant le mélange du composé de moulage en matière plastique (3), afin de modifier les surfaces de la matière de conversion (4).

18. Procédé selon la revendication 17,
**caractérisé en ce que**
de l'éther monométhylique de diéthylèneglycol est employé comme modificateur de surface.

19. Procédé selon l'une des revendications 13 à 18,
**caractérisé en ce que**
un agent de démoulage ou un agent de séparation est mélangé au composé de moulage en matière plastique avant le mélange avec la matière de conversion (4).

20. Procédé selon la revendication 19,
**caractérisé en ce que**
l'agent de démoulage est un agent de démoulage solide à base de cire ou un savon métallique avec des acides carboxyliques à chaînes longues, en particulier des stéarates.

21. Procédé selon l'une des revendications 9 à 20,
**caractérisé en ce que**
des charges de remplissage anorganiques, telles que du TriO₂, du ZrO₂ ou du α-Al₂O₃, sont mélangées en outre au composé de moulage en matière plastique, par l'intermédiaire desquelles l'indice de réfraction du composé de moulage est augmenté.

22. Procédé selon l'une des revendications 13 à 20,
**caractérisé en ce que**
le composé de moulage en matière plastique (3) et la matière de conversion (4), ainsi que, le cas échéant, d'autres charges de remplissage sont mélangés en étant, dans un premier temps, mixés de manière grossière, puis le mélange est broyé dans un broyeur, tel qu'un broyeur à billes, permettant d'obtenir de ce fait une poudre homogène et très fine.

23. Procédé selon la revendication 22,
**caractérisé en ce que**
le composé de moulage en matière plastique (3) est broyé avant le mélange avec la matière de conversion (4) et, le cas échéant, les autres charges de remplissage dans un broyeur, tel qu'un moulin à café.

24. Procédé selon l'une des revendications 9 à 23,
**caractérisé en ce que**
le composé de moulage mélangé contient les éléments suivants:
a) un composé de moulage en matière plastique dont la teneur est ≥ 60 % ;
b) une matière de conversion dont la teneur est > 0 % et ≤ 40 % ;
c) un agent d'adhérence dont la teneur est ≥ 0 % et ≤ 3 % ;
d) un agent de démoulage dont la teneur est ≥ 0 % et ≤ 2 % ;
e) un modificateur de surface dont la teneur est ≥ 0 % et ≤ 5 % ;
f) un stabilisant à l'oxydation dont la teneur est ≥ 0 % et ≤ 5 % (par exemple à base de phosphite ou à base de phénols à encombrement stérique) ; et
g) un stabilisant à la lumière UV dont la teneur est ≥ 0 % et ≤ 2 %.

25. Procédé selon l'une des revendications 9 à 24,
**caractérisé en ce que**
la source lumineuse est réalisée en tant qu'élément de construction pouvant être monté en surface, **en ce que** le composé de moulage est moulé de telle sorte que des connexions pour le réseau de conducteurs (11, 12) sont extraites latéralement en dehors du composé de moulage sur une face de montage de la source de lumière blanche produite, en formant des surfaces de montage (11A, 12A) horizontales.
